(19)

**Europäisches Patentamt**

**European Patent Office**

**Office européen des brevets**

(11) **EP 4 657 489 A2**

(12) # EUROPEAN PATENT APPLICATION

(43) Date of publication:
**03.12.2025 Bulletin 2025/49**

(21) Application number: **25174607.9**

(22) Date of filing: **06.05.2025**

(51) International Patent Classification (IPC):
***H01J 37/22*** (2006.01)   ***H01J 37/26*** (2006.01)

(52) Cooperative Patent Classification (CPC):
**H01J 37/222; H01J 37/265**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **07.05.2024 US 202418657534**

(71) Applicant: **FEI COMPANY
Hillsboro, OR 97124 (US)**

(72) Inventors:
- **JANSSEN, Bart
  Eindhoven (NL)**
- **FRANKEN, Erik
  Nuenen (NL)**

(74) Representative: **Boult Wade Tennant LLP
Salisbury Square House
8 Salisbury Square
London EC4Y 8AP (GB)**

(54) **DRIFT COMPENSATION FOR RADIATION-SENSITIVE SPECIMENS**

(57)   In one example, a method performed via a computing device for providing support to a charged particle beam system includes computing a drift estimate based at least in part on a first set of image frames acquired with a charged particle beam column and a detector from a first portion of a sample. The method also includes configuring the charged particle beam column and the detector to acquire a second set of image frames from a second portion of the sample. The method further includes performing drift compensation during acquisition of the second set of image frames based at least in part on the drift estimate.

EP 4 657 489 A2

**Description**

CROSS-REFERENCE TO RELATED APPLICATION

This application claims priority to US Non-Provisional Application 18/657,534, filed May 7, 2024, the disclosure of which is incorporated herein by reference in its entirety.

TECHNICAL FIELD

Various examples relate generally, but not exclusively, to electron microscopy components, instruments, systems, and methods.

SUMMARY

One of the factors that can affect the quality of high-resolution electron-microscope images is drift, a phenomenon inherent to many electron-microscopy systems. In some examples, drift induces a slowly fading lateral translation of the electron-microscope image projected onto the camera, which causes blurring of the image when the image is being captured by the camera. A controlled actuation system, often referred to as "stage," can be used to move the sample holder during the image-acquisition process to counteract the drift-induced motion and make the sample nearly motionless in the view of the camera. Alternatively or in addition, active optical control of electron-beam parameters can be used to counteract the drift-induced motion and cause the image projected onto the imaging plane to be nearly stationary thereat.

An example drift-compensation algorithm needs to obtain a relatively accurate drift estimate before the counter-acting stage actuation and/or active optical beam control can be applied. The accuracy of the initial drift estimate typically directly correlates with the radiation dose to which the sample is subjected, and a significant radiation dose may be needed before the initial drift estimate becomes sufficiently accurate for high-resolution imaging purposes. However, for radiation-sensitive specimens, such as biological molecules or complexes present in the sample, the irreversible damage inflicted on the specimen by the electron beam during the initial drift estimation may be of such magnitude that the subsequently acquired high-resolution image of the specimen is rendered substantially unusable.

Disclosed herein are, among other things, various examples, aspects, features, and embodiments of an electron-microscopy system capable of drift-compensation without a need to expose the sample's portion of interest (POI) to a relatively high radiation dose typically expected during high-resolution imaging. In one example, the electron-microscopy system has a fast controllable beam deflector and employs a drift-estimation algorithm that locks on the drift-induced motion when the beam deflector places the electron beam into a first position on the sample and remains locked on the drift-induced motion after the beam deflector moves the electron beam from the first position to a different second position on the sample. When the second position is selected to overlap with the sample's POI containing the radiation-sensitive specimen intended for high-resolution imaging, the radiation-sensitive specimen is beneficially not subjected to the radiation dose associated with obtaining an accurate initial drift estimate.

One example provides a method performed via a computing device for providing support to a charged particle beam system, the method comprising: computing a drift estimate based at least in part on a first set of image frames acquired with a charged particle beam column and a detector from a first portion of a sample; configuring the charged particle beam column and the detector to acquire a second set of image frames from a second portion of the sample; and performing drift compensation during acquisition of the second set of image frames based at least in part on the drift estimate.

Another example provides a charged particle beam system, comprising: a charged particle beam column configured to direct a beam of charged particles to a sample; a detector configured to detect a response of the sample to the beam of charged particles; and an electronic controller configured to: compute a drift estimate based at least in part on a first set of image frames acquired with the charged particle beam column and the detector from a first portion of the sample; configure the charged particle beam column and the detector to acquire a second set of image frames from a second portion of the sample; and perform drift compensation during acquisition of the second set of image frames based at least in part on the drift estimate.

Further aspects of the invention are set out in the following numbered clauses:

> Clause 1. A method performed via a computing device for providing support to a charged particle beam system, the method comprising:
>
>> computing a drift estimate based at least in part on a first set of image frames acquired with a charged particle beam column and a detector from a first portion of a sample;
>> configuring the charged particle beam column and the detector to acquire a second set of image frames from a second portion of the sample; and
>> performing drift compensation during acquisition of the second set of image frames based at least in part on the drift estimate.
>
> Clause 2. The method of clause 1, wherein performing the drift compensation includes controlling actuation of a stage with which the sample is coupled.
>
> Clause 3. The method of clause 1, wherein performing the drift compensation includes controlling a charged particle optical element of the charged particle beam column to correct for the drift estimate.

Clause 4. The method of clause 1, further comprising modulating a beam of charged particles directed to the sample via the charged particle beam column in accordance with a pulsed gating signal.

Clause 5. The method of clause 4, wherein the pulsed gating signal is configured to have a first duty cycle value when the beam is directed to the first portion of the sample and a different second duty cycle value when the beam is directed to the second portion of the sample.

Clause 6. The method of clause 1,

wherein the first set of image frames includes a first subset and a second subset, the second subset being acquired later than the first subset; and

wherein performing the drift compensation includes performing the drift compensation during acquisition of the second subset based at least in part on a preliminary value of the drift estimate computed based at least in part on the first subset.

Clause 7. The method of clause 1,

wherein the second set of image frames includes a first subset and a second subset, the second subset being acquired later than the first subset; and

wherein the method further comprises updating the drift estimate based at least in part on the first subset; and

wherein the performing the drift compensation includes performing the drift compensation during acquisition of the second subset based at least in part on the updated drift estimate.

Clause 8. The method of clause 1, wherein computing the drift estimate includes determining one or more displacement vectors based at least in part on the first set of image frames.

Clause 9. The method of clause 1, wherein computing the drift estimate includes:

computing a sequence of drift measures using different subsets of the first set of image frames; and

determining the drift estimate based at least in part on the sequence.

Clause 10. The method of clause 1, further comprising updating the drift estimate using one or more image frames of the second set of image frames.

Clause 11. The method of clause 10,

wherein computing the drift estimate includes:

computing a first sequence of drift measures using different subsets of the first set of image frames; and
applying the first sequence to a smoothing filter; and

wherein updating the drift estimate includes:

computing a second sequence of drift measures using different subsets of the second set of image frames; and
applying the second sequence to the smoothing filter after the first sequence.

Clause 12. The method of clause 11, wherein a drift measure in the first and second sequences is selected from a group consisting of a position value, a velocity value, and an acceleration value.

Clause 13. The method of clause 11, wherein the smoothing filter is configured to perform multiple predictions at a juncture between the first and second sequences.

Clause 14. A non-transitory computer-readable medium storing instructions that, when executed by the computing device, cause the computing device to perform operations comprising the method of clause 1.

Clause 15. A charged particle beam system, comprising:

a charged particle beam column configured to direct a beam of charged particles to a sample;
a detector configured to detect a response of the sample to the beam of charged particles; and
an electronic controller configured to:

compute a drift estimate based at least in part on a first set of image frames acquired with the charged particle beam column and the detector from a first portion of the sample;
configure the charged particle beam column and the detector to acquire a second set of image frames from a second portion of the sample; and
perform drift compensation during acquisition of the second set of image frames based at least in part on the drift estimate.

Clause 16. The charged particle beam system of clause 15, further comprising a stage with which the sample is coupled, wherein the electronic controller is configured to perform the drift compensation by controlling actuation of the stage based at least in part on the drift estimate.

Clause 17. The charged particle beam system of clause 15, wherein the electronic controller is configured to perform the drift compensation by controlling the charged particle beam column to perform beam deflection based at least in part on the drift estimate.

Clause 18. The charged particle beam system of clause 15, wherein the first set of image frames and the second set of image frames represent transmission electron microscope (TEM) images.

Clause 19. The charged particle beam system of clause 15, wherein the first set of image frames and the second set of image frames represent scanning transmission electron microscope (STEM) images.

Clause 20. The charged particle beam system of clause 15, wherein the first portion and the second portion are non-overlapping portions of the sample.

BRIEF DESCRIPTION OF THE DRAWINGS

The foregoing aspects and many of the attendant advantages of the present disclosure will become more readily appreciated as the same become better understood by reference to the following detailed description, when taken in conjunction with the accompanying drawings.

FIG. 1 is a block diagram illustrating a scientific instrument according to some examples.

FIG. 2 is a block diagram illustrating a drift-compensation control loop used in the scientific instrument of FIG. 1 according to some examples.

FIG. 3 is a flowchart illustrating a drift estimation algorithm used in the drift-compensation control loop of FIG. 2 according to some examples.

FIG. 4 graphically illustrates the performance of the drift estimation algorithm of FIG. 3 according to one example.

FIG. 5 pictorially illustrates operations of a deflector driver used in the drift-compensation control loop of FIG. 2 according to one example.

FIG. 6 is a flowchart illustrating a drift-compensation method implemented using the control loop of FIG. 2 according to some examples.

FIGS. 7A-7B graphically illustrate optional beam blanking during execution of the drift-compensation method of FIG. 6 according to some examples.

FIG. 8 is a flowchart illustrating a method performed via a computing device for providing support to the scientific instrument of FIG. 1 according to various examples.

FIG. 9 is a block diagram illustrating a computing device according to some examples.

DETAILED DESCRIPTION

Various embodiments disclosed herein can beneficially be used in different charged particle beam (CPB) systems. An example CPB system may include an electron beam column or a focused ion-beam (FIB) column. Some CPB systems may include both of these columns, e.g., oriented with respect to one another at an angle between approximately 30 degrees and 60 degrees. For illustration purposes and without any implied limitations, some example embodiments are described below in reference to CPB systems employing electron beam columns. From the provided description, a person of ordinary skill in the pertinent art will be able to make and use other embodiments, e.g., pertaining to CPB systems employing FIB columns, without any undue experimentation.

Without being bound to a particular physical mechanism or phenomenon, image drift in a CPB system can result, at least in part, from residual motion in stage components (e.g., hysteresis in stage actuators), mechanical vibration of the sample (e.g., originating in rotating components of the system, ambient vibration, etc.), and/or motion of or in the sample (e.g., thermal dynamic response to energy of the beam being transferred into the material of the sample as crystal vibrations, increased Brownian motion, phase change, thermal expansion/contraction, etc.). Techniques for correction of drift can be targeted at damping, compensating, or otherwise attenuating the various sources of drift. These include, among others, passive vibration isolation (e.g., mechanical damping of periodic vibration), active electro-mechanical control (e.g., modifying actuator motion control inputs to predict and/or compensate for overshoot, undershoot, and/or hysteresis during stage motion), and active optical control of beam parameters (e.g., modifying one or more operating parameters of a CPB optical column).

In the case of active electro-mechanical control, the control signal used to drive the stage in one or more degrees of freedom (e.g., X-Y-Z and tilt) can be modified using a control model (e.g., feedback-feed forward) to adjust the signal as a function of time and/or amplitude (e.g., voltage) to attenuate and/or correct for drift. In one example, a transfer function describing the motion properties of a stage can be derived from calibrated measurement of the stage. The transfer function, in turn, can be used to generate actuation instructions based at least in part on a drift measured in an image, for example, as part of a feedback control loop linking image processing outputs to stage control signal inputs.

In the case of active optical control, a steering signal that is provided to a steering assembly of the optical column (e.g., a set of electrostatic and/or magnetic deflectors placed in the column and used to steer the beam of charged particles) can be modulated in time to compensate for drift in the image. In this context, modulation of the steering signal can include combining the steering signal (e.g., as a linear combination of time-series voltage signals) with a drift offset signal. This combination can be effected by control circuitry of the CPB column, in hardware for example, and/or can be derived from image processing applications and/or hardware of the system to output a drift-corrected steering signal as a set of time-series voltage signals to steer a beam of charged particles in one or more dimensions as a function of time.

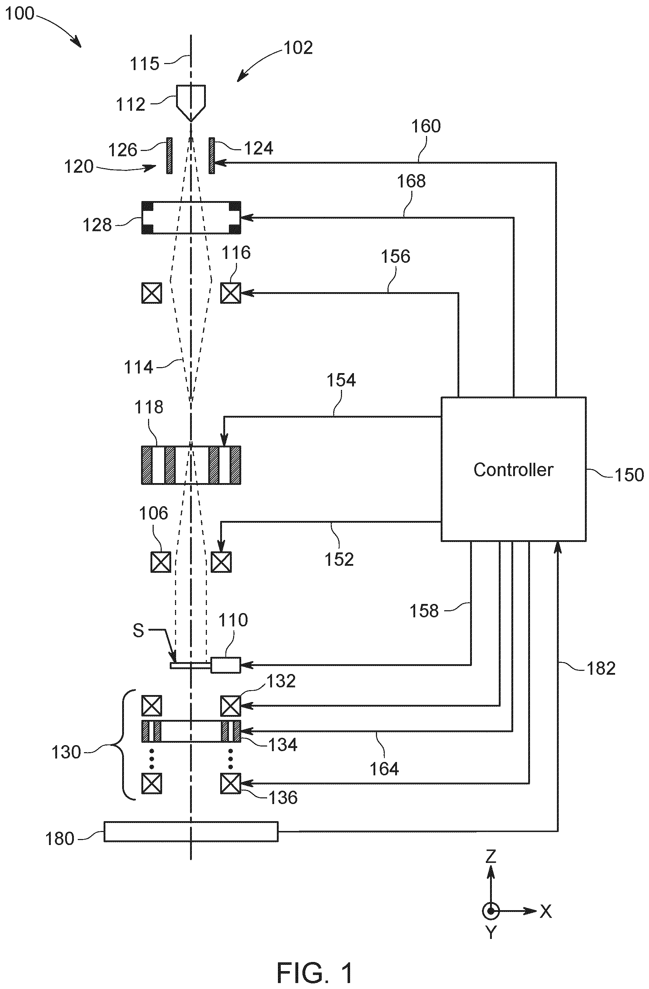

FIG. 1 is a block diagram illustrating a scientific instrument 100 according to some examples. A sample S to be interrogated using the scientific instrument 100 is mounted in a controlled actuation system (stage) 110 as indicated in FIG. 1. An electronic controller 150 operates to generate a control signal 158, in response to which the stage 110 translates the sample S by the specified amounts. In various examples, the stage 110 is configured to move the sample S parallel to the XY-coordinate plane, with the corresponding coordinate system being indicated by the XYZ-coordinate triad shown in FIG. 1.

The scientific instrument 100 includes an electron beam column 102. In the example shown, the electron beam column 102 includes an electron source 112 and two or more pre-specimen electron-beam lenses, only two of which, i.e., a first condenser lens 116 and a second condenser lens 106, are schematically shown in FIG. 1 for illustration purposes. In some examples, one or both of the lenses 106 and 116 are implemented as multi-component lenses, e.g., including two or more respective constituent lenses. In some examples, a different (from two) number of pre-specimen electron-beam lenses may be used in the electron beam column 102. Using different configurations of the sets of pre-specimen and post-specimen electron-beam lenses, the electron beam column 102 can be configured for transmission electron microscopy (TEM) measurements or for scanning transmission electron microscopy (STEM) measurements. For illustration purposes and without any implied limitations, the electron beam column 102 is shown in FIG. 1 in a TEM configuration.

In operation, the electron source 112 generates an electron beam 114 propagating generally along a longitudinal axis 115 of the electron beam column 102.

Electron-beam lenses 106 and 116 are operated to generate electric and magnetic fields that affect electron trajectories in the electron beam 114. Control signals 152, 156 generated by the electronic controller 150 are used to change the strengths and/or spatial configurations of the fields and impart desired properties on the electron beam 114. In general, the electron-beam lenses 106 and 116, control signals 152 and 156, and other pertinent components of the scientific instrument 100 can be used to perform various operations and support various functions, such as beam focusing, aberration mitigation, aperture cropping, filtering, etc. The electron beam column 102 further includes a first beam deflector 128 and a second beam deflector 118 that can deflect the electron beam 114 in response to control signals 168 and 154, respectively, received from the electronic controller 150. In operation, the first beam deflector 128 can be used in a TEM mode to move the illumination spot produced by a collimated electron beam across the sample S, e.g., from a first position to a second position in a relatively short time. The second beam deflector 118 can be used in a STEM mode to raster a focused electron beam across the sample S.

The electron beam column 102 also includes a set 130 of post-specimen electron-beam optics. The optics set 130 typically includes one or more electron-beam lenses and one or more apertures. In some examples, the electron-beam lenses include an objective lens 132, an intermediate lens (not explicitly shown in FIG. 1), and a projector lens 136. In some examples, some or all of the objective lens 132, the intermediate lens, and the projector lens 136 are implemented as multi-component lenses, e.g., including two or more respective constituent lenses. In operation, the electronic controller 150 generates appropriate control signals to operate the post-specimen electron-beam lenses of the optics set 130 in two or more operating modes, including an imaging mode and a diffraction mode. For imaging applications described herein below, the optics set 130 is configured to operate in the imaging mode. In this mode, the objective aperture is inserted in a back focal plane of the objective lens 132. The electrons transmitted through the aperture pass through the intermediate lens and are projected by the projector lens 136 onto a two-dimensional (2D) pixelated electron detector (e.g., a camera) 180 to form an image of the sample S thereon. The detector 180 operates to capture the image, and a detector readout signal 182 carrying a time-stamped image frame representing the captured image is received by the electronic controller 150 for processing.

In the example shown, the set 130 of post-specimen electron-beam optics also includes an image deflector 134. The image deflector 134 is configured to translate the image formed on the electron detector 180 along a selected direction within the XY coordinate plane in response to a control signal 164 received from the electronic controller 150. For example, in the TEM mode, the image deflector 134 can be used to partially compensate or substantially cancel the shift of the image on the detector 180 when the deflector 128 changes the beam deflection angle in the pre-specimen optics of the electron beam column 102.

In some examples, the electron beam column 102 also includes an optional beam blanker 120. In the example shown, the beam blanker 120 is positioned between the electron source 112 and the first beam deflector 128. In other examples, the beam blanker 120 can be placed in another suitable pre-specimen location in the electron beam column 102.

In the example shown, the beam blanker 120 includes an electrostatic beam deflector comprising first and second electrodes 124, 126. When a sufficiently strong electric field is present between the electrodes 124 and 126 (due to appropriate electrical biasing thereof), the electric field interacts with the electron beam 114, thereby deflecting the beam away from the longitudinal axis 115. A beam catcher (not explicitly shown in FIG. 1) then intercepts (stops) the deflected electron beam 114 and directs the corresponding electrical current to a charge sink, e.g., to a ground terminal of the electron beam column 102. When an electric field is absent between the electrodes 124 and 126, the electron beam 114 passes through the beam blanker 120 undeflected and continues to propagate along the longitudinal axis 115 toward the sample S. In other examples, other suitable physical mechanisms for gating the electron beam 114 in the beam blanker 120 can also be implemented. In other examples, relatively fast magnetic beam deflectors can also be used in the beam blanker 120.

In response to a gating control signal 160 received from the electronic controller 150, the beam blanker 120 operates to stop and pass the electron beam 114 at different times. The electronic controller 150 is used to set various parameters of the gating control signal 160. Common control over the gating control signal 160 and the deflector control signals 154, 164, 168 exerted by the electronic controller 150 enables any desired synchronization and/or correlation between those control signals.

In a TEM configuration, the electron beam column 102 operates to project a broad, collimated electron beam onto the sample S, e.g., as indicated in FIG. 1. In contrast, for STEM measurements, pre-specimen lenses of the electron beam column 102 are configured such that the electron beam is focused to a fine spot (e.g., 0.05 - 0.2 nm in diameter), which is then scanned over the sample S such that the electron beam remains substantially parallel to the longitudinal axis 115 at each point on the sample S along the scan path, e.g., following a raster pattern. Example hardware differences between the TEM and STEM configurations of the scientific instrument 100 include the use in the STEM configuration of additional scanning coils, different detectors, and corresponding auxiliary circuitry. In some examples, electron detectors used for STEM measurements may include one or more of a bright-field (BF) detector, an annular dark-field (ADF) detector, and a high-angle annular dark-field (HAADF) detector. In some examples, the electron beam column 102 and the instrument 100 are switchable between the TEM and STEM modes of operation.

The relative order and positions of various optical elements in the electron beam column 102 shown in FIG. 1 represent just one example of how those optical elements can be arranged. In other examples, other relative orders and/or positions of the optical elements in the electron beam column 102 can also be implemented.

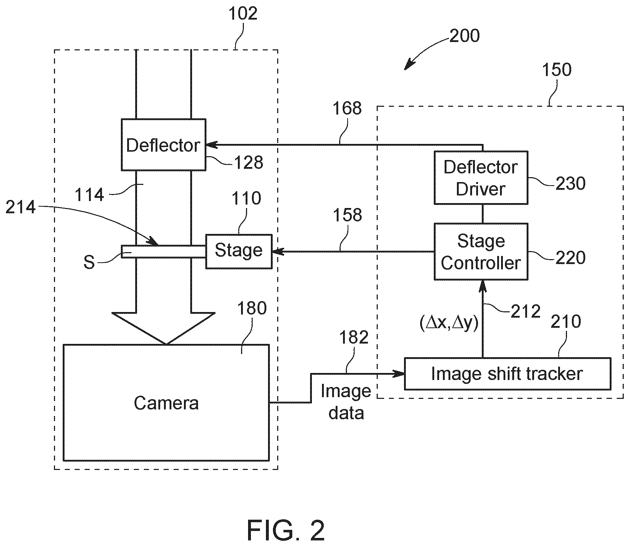

FIG. 2 is a block diagram illustrating a drift-compensation control loop 200 used in the scientific instrument 100 according to some examples. Such examples represent the above-mentioned cases of active electro-mechanical control. A set of modules of the electronic controller 150 used in the control loop 200 includes an image shift tracker 210, a stage controller 220, and a deflector driver 230. The image shift tracker 210 receives the detector readout signals 182 from the camera 180 and operates to determine drift-induced displacements ($\Delta x$, $\Delta y$) of the sample S as a function of time by processing the corresponding pairs of image frames, e.g., as described in more detail below. A stream 212 of the determined drift-induced displacements ($\Delta x$, $\Delta y$) is processed by the stage controller 220 using a drift-estimation algorithm described in more detail below to determine motion setpoints, which are then fed via the control signal 158 to the stage 110 to counteract the drift-induced motion of the image of the sample S with respect to the camera 180. The deflector driver 230 operates to generate the control signal 154 for the beam deflector 128 of the electron beam column 102 to move an electron-beam illumination spot 214 across the sample S in a manner that protects a radiation-sensitive portion of interest (POI) in the sample S from overexposure to the electron beam 114 without disrupting the drift-estimation algorithm run by the stage controller 220.

In some examples, the image shift tracker 210 is configured to use image cross-correlation to measure the drift-induced displacement vector ($\Delta x$, $\Delta y$) of the sample S. For two successive pixelated images $f$ and $g$ received by the image shift tracker 210 via the detector readout signal 182, a sequence of image-processing operations performed by the image shift tracker 210 for this purpose includes the following example operations. First, Fourier transforms **F** and **G** of the images $f$ and $g$ are computed as expressed by Eqs. (1)-(2):

$$\mathbf{F} = \text{FFT}\{f\} \qquad (1)$$

$$\mathbf{G} = \text{FFT}\{g\} \qquad (2)$$

where FFT denotes the fast Fourier transform operation. Next, a correlogram, R, is computed as follows:

$$R = \mathbf{F} \circ \mathbf{G}^* \qquad (3)$$

where ∘ denotes the Hadamard product; and * denotes the complex conjugate. In some examples, an optional Fourier filtering operation can be added in the computation of $R$ to achieve a bandpass filtering behavior by suppressing the contribution of low and high frequencies. Then, a cross-correlation image, r, is obtained by applying an inverse Fourier transform to the correlogram R:

$$r = \text{IFFT}\{R\} \qquad (4)$$

where IFFT denotes the inverse fast Fourier transform operation. Finally, the displacement vector $(\Delta x, \Delta y)$ is determined by finding the coordinates of the maximum $r_{ij}$ in the cross-correlation image $r$ as follows:

$$(\Delta x, \Delta y) = \operatorname*{argmax}_{(i,j)}\{r\} \qquad (5)$$

where $i$ and $j$ are the pixel indices corresponding to the x and y coordinates, respectively. In some examples, a model function is optionally fit to the peak in the cross-correlation image to obtain subpixel localization accuracy. The operations expressed by Eqs. (1)-(5) are repeated for different pairs of pixelated images received by the image shift tracker 210 via the detector readout signals 182. The sequence of measured displacement vectors $(\Delta x, \Delta y)$ obtained in this manner forms the stream 212, which is directed to the stage controller 220.

In other examples, the image shift tracker 210 may be configured to use other suitable image registration, correlation, and/or tracking techniques to determine the displacement vectors $(\Delta x, \Delta y)$ and to generate the stream 212.

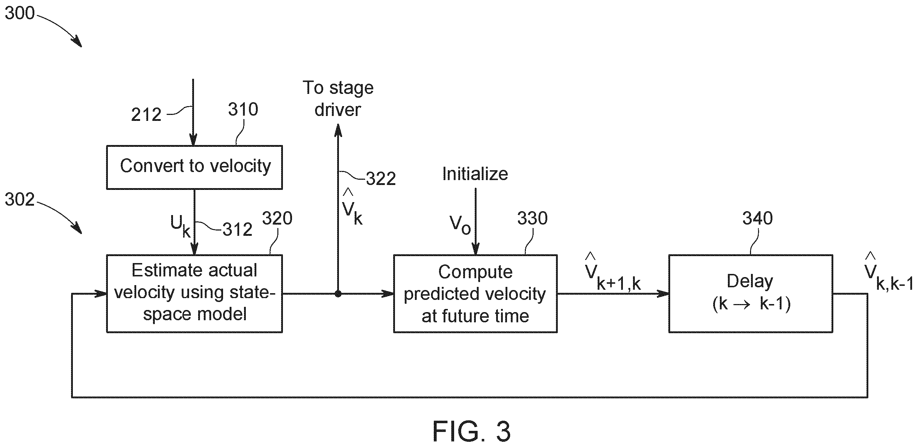

FIG. 3 is a flowchart illustrating a drift-estimation algorithm 300 used in the stage controller 220 according to some examples. The algorithm 300 computes an estimated drift velocity vector $\hat{V}_k$ at time $k$ based on the stream 212 of measured displacement vectors $(\Delta x_k, \Delta y_k)$ generated by the image shift tracker 210, e.g., as described above. A stream 322 of the estimated drift velocity vectors $\hat{V}_k$ is directed to a driver circuit connected to the stage 110 and is used thereby, after preprocessing and/or mapping, to generate the control signal 158 for the stage 110 (also see FIGS. 1-2).

A block 310 of the algorithm 300 operates to convert the stream 212 of measured displacement vectors $(\Delta x_k, \Delta y_k)$ into a corresponding stream 312 of measured velocity values $U_k$. Each velocity $U_k$ is a vector value having two respective components, $(u_x, u_y)$, computed as follows:

$$u_x = \Delta x_k / \Delta t_k \qquad (6)$$

$$u_y = \Delta y_k / \Delta t_k \qquad (7)$$

where $(\Delta x_k, \Delta y_k)$ is the measured displacement vector corresponding to the time $k$; and $\Delta t_k$ is the time difference between the corresponding two pixelated images $f$ and $g$. In some examples, the value of $\Delta t_k$ is determined by computing a time difference between the respective timestamps of the image frames carrying the images $f$ and $g$. The stream 312 of measured velocity values $U_k$ generated in this manner is applied to a Kalman filter 302 that includes blocks 320, 330, and 340.

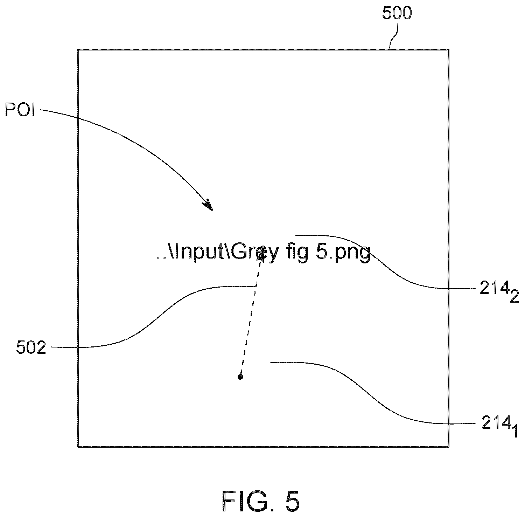

The Kalman filter 302 implements Kalman filtering, also referred to as linear quadratic estimation (LQE). Kalman filtering uses a series of measurements observed over time, including statistical noise and other inaccuracies, and produces estimates of unknown variables that tend to be more accurate than those based on a single measurement alone. In the algorithm 300, the stream 312 represents the series of measurements observed over time, and the stream 322 represents the produced estimates. In various examples, the stream 312 includes a first stream portion corresponding to a first position of the electron beam 114 on the sample S and a second stream portion corresponding to a different second position of the electron beam 114 on the sample S. An example of such first and second positions is described in more detail in reference to FIG. 5. The first and second stream portions of the stream 312 are successively applied to the Kalman filter 302. The Kalman filter 302 uses both of these stream portions to generate the stream 322.

The Kalman filter 302 implements an example of a recursive algorithm that can operate in real time, using only the present velocity measurement $U_k$ and the velocity state $\hat{V}_{k,k-1}$ (including the corresponding covariances) calculated in the previous iteration. As used herein, the term "real time" refers to a computer-based process that controls a corresponding environment by receiving data, processing the received data, and generating a response sufficiently quickly to affect the environment without significant delay. Real-time responses are often understood to be on the order of milliseconds, or sometimes microseconds. In the context of the control loop 200, "real-time" updates mean that the velocity state $\hat{V}_{k,k-1}$ sufficiently accurately represents the corresponding drift-induced motion of the sample S at the time $k$.

The blocks 320 and 330 represent two distinct processing phases of the Kalman filter 302 referred to as the update phase and the prediction phase, respectively. In the update phase 320, the estimated drift velocity vector $\hat{V}_k$ is computed based on the previously computed velocity state $\hat{V}_{k,k-1}$, the present velocity measurement $U_k$, and the applicable state-space model. A representative example of the state-space model that can be used for the calculations of the block 320 is described, e.g., in E.P. van Horssen, B.J. Janssen, A. Kumar, et al., "Image-based feedback control for drift compensation in an electron microscope," IFAC Journal of Systems and Control, 2020, v. 11, pp. 100074-100088, which is incorporated herein by reference in its entirety. In various additional examples, other suitable state-space models can similarly be used in the block 320.

In the prediction phase 330, the predicted velocity state $\hat{V}_{k+1,k}$ (including the corresponding covariances) is computed based on the estimated drift velocity vector $\hat{V}_k$ and a dynamic model of the drift. In some examples, the dynamic model of the drift can be an exponential decay model. For a first iteration, for which the estimated drift velocity vector $\hat{V}_k$ is not available, an initial velocity guess $V_0$ is used instead of $V_k$. In some examples, the initial velocity guess is $V_0=0$.

Operations of the block 340 are used to update the time indices of various computed variables to prepare the Kalman filter 302 for a next round of computations corresponding to a next velocity measurement $U_k$ supplied by the block 310 in response to a next received value of the displacement vector ($\Delta x_k$, $\Delta y_k$). The presence of the block 340 in the processing loop of the Kalman filter 302 is a manifestation of the recursive nature of the corresponding computations.

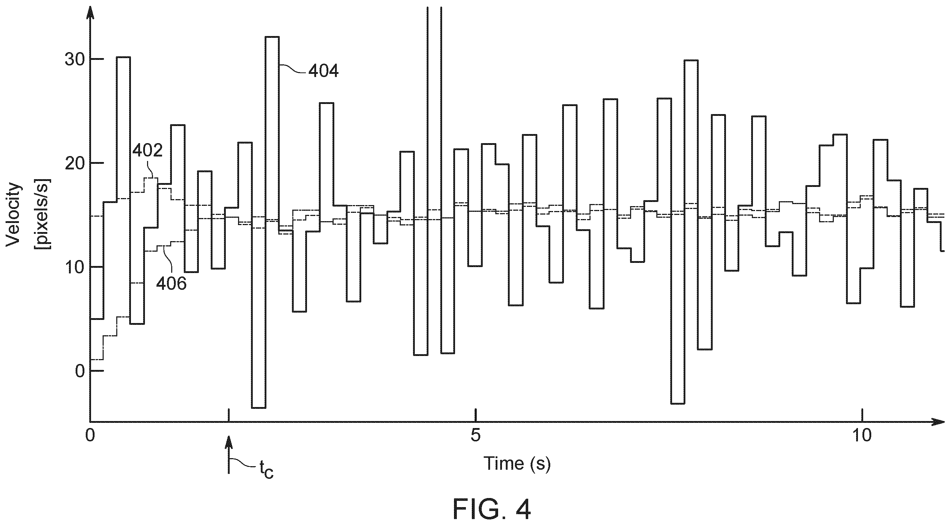

FIG. 4 graphically illustrates the performance of the algorithm 300 according to one example. The data shown in FIG. 4 are obtained via computer simulations. In the example shown, a trace 402 represents the "ground-truth" drift velocity, which is not directly observable in the scientific instrument 100. A trace 404 represents the stream 312 of the measured velocity values $U_k$. Significant deviations of the trace 404 from the ground-truth trace 402 are evident. These deviations are manifestations of the noise affecting the velocity measurements. A first-order-hold (FOH) approach to compensating the drift-induced motion of the sample S based directly on the immediate velocity values $U_k$ will disadvantageously produce a scatter in the control signal 158 that is similar to the scatter of the trace 404 around the trace 402.

A trace 406 shown in FIG. 4 represents the stream 322 of the estimated drift velocity vectors $\hat{V}_k$ generated with the algorithm 300. In this example, the initial velocity guess applied to the block 330 of the algorithm 300 is $V_0=0$. Several iterations of the Kalman filter 302 are needed before the trace 406 converges to the ground-truth trace 402. The corresponding convergence time is denoted in FIG. 4 as $t_c$. At times $t > t_c$, the trace 406 is substantially locked with the ground-truth trace 402.

FIG. 5 pictorially illustrates operations of the deflector driver 230 according to one example. More specifically, FIG. 5 shows a low-resolution TEM image 500 of the sample S. A central portion of the image 500 represents a POI in which a radiation-sensitive specimen is located. The circles labeled $214_1$ and $214_2$ (also see FIG. 2) represent first and second positions, respectively, of the electron beam 114 on the sample S. The first position $214_1$ is outside the POI. The second position $214_2$ overlaps with the POI. To move the electron beam 114 from the first position $214_1$ to the second position $214_2$ as indicated in FIG. 5 by a beam-translation vector 502, the deflector driver 230 changes the beam-deflector control signal 168 applied to the beam deflector 128 in a step-like manner. As a result of that change, the electron beam 114 substantially jumps from the first position $214_1$ to the second position $214_2$ without dwelling any significant time on other points along the length of the beam-translation vector 502.

In some examples, the electron beam 114 can alternatively be moved from the first position $214_1$ to the second position $214_2$ on the sample S by operation of the stage 110 instead of the beam deflector 128. In such examples, the stage controller 220 changes the control signal 158 applied to the stage 110 in a step-like manner while the beam deflection angle remains unchanged. As a result of that change in the control signal 158, the stage 110 moves in the opposite direction to that of the vector 502, which causes the electron beam 114 to move relative to the sample S from the first position $214_1$ to the second position $214_2$ as indicated in FIG. 5.

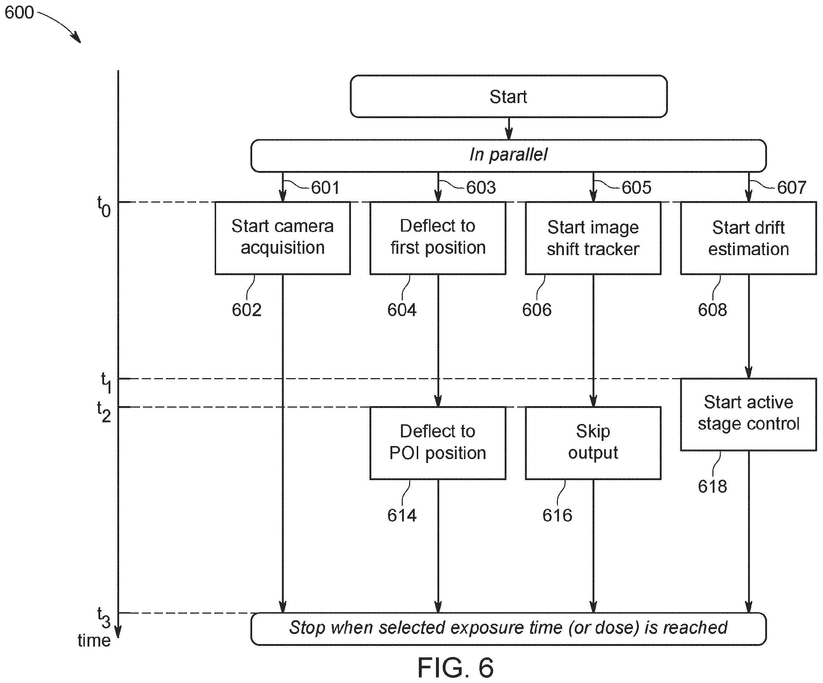

FIG. 6 is a flowchart illustrating a drift-compensation method 600 implemented using the control loop 200 according to some examples. The method 600 has parallel threads 601, 603, 605, and 607 corresponding to the camera 180, the deflector driver 230, the image shift tracker 210, and the stage controller 220, respectively. A timeline shown in FIG. 6 to the left of the threads 601, 603, 605, and 607 indicates relative timing of different operations performed within the threads. The method 600 is described below in continued reference to FIGS. 1-6.

The threads 601, 603, 605, and 607 include control operations 602, 604, 606, and 608, respectively, performed at time $t=t_0$. The control operation 604 configures the deflector driver 230 to generate the control signal 168 that causes the beam deflector 128 to deflect the electron beam 114 such that the electron-beam illumination spot is in the first position $214_1$ (also see FIG. 5). In some examples, the first position $214_1$ is selected such that the corresponding area of the sample S includes a relatively high contrast feature and is relatively tolerant to the electron irradiation. The control operation 602 causes the camera 180 to start acquiring a sequence of image frames of the illuminated area of the sample S, e.g., at regular time intervals. Each of the acquired image frames is time-stamped and provided to the image shift tracker 210 via the readout signal 182. The control operation 606 causes the image shift tracker 210 to start processing pairs of the image frames received from the camera 180 to determine the corresponding displacement vectors ($\Delta x_k$, $\Delta y_k$), e.g., as described above in reference to Eqs. (1)-(5). The control operation 608 causes the stage controller 220 to start the drift-estimation algorithm 300 and to begin processing the stream 212 and determining the estimated drift velocity vectors $\hat{V}_k$.

The thread 607 also includes a control operation 618 performed at time $t=t_1$. The threads 603 and 605 also include control operations 614 and 616, respectively, performed at time $t=t_2$. In various examples, the following relative timing of the times $t_1$ and $t_2$ can be implemented: (i) $t_1 < t_2$ as illustratively shown in FIG. 6 without any implied limitation; (ii) $t_1 = t_2$; or (iii) $t_1 > t_2$. In each of such examples, the time difference $(t_2 - t_0)$ is typically selected to be larger than the convergence time $t_c$ described above in reference to FIG. 4.

The control operation 618 causes the stage controller 220 to start actuating the stage 110 based on the stream 322 of the estimated drift velocity vectors $\hat{V}_k$ computed with the algorithm 300. As illustrated by FIG. 4, these actuations tend to relatively accurately counteract the drift-induced motion of the sample S, thereby making the sample nearly motionless in the view of the camera 180.

The control operation 614 configures the deflector driver 230 to change the control signal 168 applied to the beam deflector 128 such that the electron-beam illumination spot jumps from the first position $214_1$ to the second position $214_2$ within the sample S, e.g., as illustrated by the beam-translation vector 502 in FIG. 5. In some examples, the second position $214_2$ overlaps with the POI of the sample S, which may be relatively sensitive to the electron irradiation.

In some examples, the control operation 616 configures the image shift tracker 210 to skip one output for the stream 212. The skipped output corresponds to the image frame pair $f$, $g$ in which the image frame $f$ is acquired with the electron beam 114 being in the first position $214_1$ and the image frame g is acquired with the electron beam 114 being in the second position $214_2$. While the Kalman filter 302 typically operates by alternating between the update phase 320 and the prediction phase 330, such alternation is not a strict requirement. For example, when a next measured velocity value $U_k$ is not received for any reason, the update phase 320 can be skipped and another instance of the prediction phase 330 can be performed using the currently existing configuration. In the art of Kalman filtering, this type of processing is referred to as the "multiple prediction procedure." Accordingly, in response to a skipped output from the image shift tracker 210, the algorithm 300 operates to skip an instance of the update phase 320 and proceeds to perform a next instance of the prediction phase 330 in accordance with the multiple prediction procedure. After the skipped output corresponding to the control operation 616, the image shift tracker 210 resumes the regular output of the displacement vectors $(\Delta x_k, \Delta y_k)$, with the displacement vectors now being measured using the image frame pairs $f$, $g$ acquired with the electron beam 114 being in the second position $214_2$. The algorithm 300 therefore also resumes the regular alternation of the update phase 320 and the prediction phase 330. In some other examples, when the deflection corresponding to the beam-translation vector 502 is relatively fast, the skipping is applied to the image shift calculation in the image shift tracker 210 instead of the above-described scenario where the skipping is applied to the stream 212. In general, the image shift tracker 210 may need to be "reinitialized" to handle the move of the beam from the first position $214_1$ to the second position $214_2$. Such reinitialization may include, for example, restarting the tracking without considering the history from one or more previous frames.

The threads 601, 603, 605, and 607 are stopped at time $t=t_3$. In some examples, the time $t_3$ is selected such that the integral electron-beam exposure of the POI during the time interval $[t_2, t_3]$ reaches a fixed threshold dose. The threshold-dose value is a configuration parameter of the method 600 and can be selected based on the contents of the POI and the electron irradiation tolerance(s) of the corresponding chemical and/or biological substances. In some other examples, the time $t_3$ is selected such that the time difference $(t_3 - t_2)$ is equal to a fixed threshold duration. Again, the threshold duration is a configuration parameter of the method 600 and can be selected based on the contents of the POI and the electron irradiation tolerance(s) of the corresponding chemical and/or biological substances.

In some examples, the method 600 may be configured to revisit the first position $214_1$ one or more times to improve the lock of the Kalman filter 302 on the drift-induced motion of the sample S or to recalibrate the drift compensation parameters. Such revisitation may be useful, for example, during lengthy acquisitions in which the accuracy of the lock gradually deteriorates in the second position $214_2$ or when the tracking in the second position $214_2$ does not lead to sufficiently accurate measurements within the time interval between the times $t_2$ and $t_3$.

After the method 600 is terminated, the stack of time-stamped image frames acquired during the time interval $[t_0, t_3]$ is typically subjected to postprocessing. Example postprocessing operations include sorting the acquired image frames into first and second batches corresponding to the time intervals $[t_0, \max(t_1, t_2)]$ and $]\max(t_1, t_2), t_3]$, respectively. The time interval $]\max(t_1, t_2), t_3]$ corresponds to the configuration of the control loop 200 in which (i) the electron beam 114 is in the second position $214_2$ and (ii) the stage controller 220 is actively actuating the stage 110 to counteract the drift-induced motion and make the sample S nearly motionless in the view of the camera 180. In some examples, the output format for the second batch is the EER format, where the acronym EER stands for Electron Event Representation. The EER format is described in detail, e.g., in U.S. Patent Application Publication No. 2019/0228949, which is incorporated herein by reference in its entirety. In some examples, the first batch is directly discarded whereas the second batch is processed obtain the scientifically relevant data.

Example postprocessing operations further include applying global and local motion correction to the second batch of image frames to compose a single high-resolution image of the POI. Suitable motion correction software is commercially available, with one representative example being the MotionCor3 software package available from the Chan Zuckerberg Imaging Institute (CZII). Depending on the intended application, further postprocessing operations can be directed to implementing cryo-electron tomography or single particle analysis.

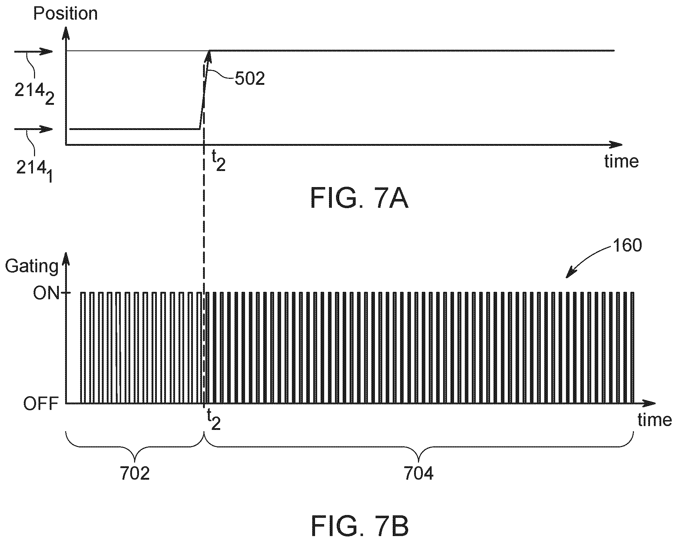

FIGS. 7A-7B graphically illustrate operations of the beam deflector 128 and the optional beam blanker 120 during execution of the method 600 according to some examples. More specifically, FIG. 7A graphically illustrates the position of the electron beam 114 as a function of time imparted on the beam by the beam deflector 128. FIG. 7B graphically illustrates the gating applied to the electron beam 114 by the beam blanker 120 as a function of time.

Referring to FIG. 7A, the electron beam 114 is in the first position $214_1$ at times $t < t_2$. The electron beam 114 moves from the first position $214_1$ to the second position $214_2$ along the beam-translation vector 502 at time $t = t_2$. The electron beam 114 is in the second position $214_2$ at times $t > t_2$.

Referring to FIG. 7B, the gating control signal 160 has first and second segments, labeled 702 and 704, respectively, with the transition from the first segment 702 to the second segment 704 occurring at the time $t = t_2$. Each of the first and second segments 702, 704 includes a respective train of gating pulses and alternates between the OFF and ON states. In the OFF state of the gating control signal 160, the beam blanker 120 stops the electron beam 114 from reaching the sample S. In the ON state of the gating control signal 160, the beam blanker 120 allows the electron beam 114 to impinge on the sample S. The electronic controller 150 operates the camera 180 such that a respective image frame is acquired by the camera in the ON state of the gating control signal 160 and is read out from the camera during the OFF state of the gating control signal 160.

In some examples, the first and second segments 702, 704 have the same pulse repetition rate (or period) but different respective ON duty cycles. More specifically, the ON duty cycle in the first segment 702 is larger than the ON duty cycle in the second segment 704. This property of the gating control signal 160 facilitates relatively fast locking of the algorithm 300 onto the drift-induced motion of the sample S and beneficially limits the radiation exposure of the POI.

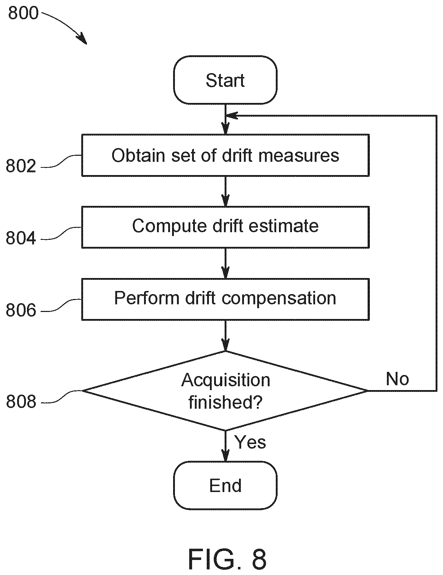

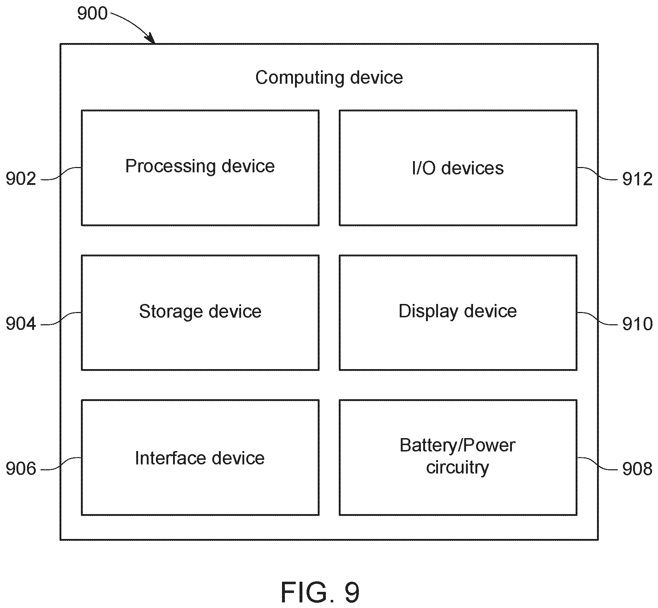

FIG. 8 is a flowchart illustrating a method 800 performed via a computing device for providing support to the instrument 100 according to various examples. In some examples, the method 800 is implemented via the controller 150 (FIG. 1). In some other examples, the method 800 is implemented via one or more computing devices 900 (FIG. 9). Different embodiments of the method 800 can be used with the scientific instrument 100 configured to operate in different configurations, such as the above-described TEM configuration and STEM configuration.

The method 800 includes obtaining a set of drift measures (in a block 802). In different examples, such set of drift measures may include a single drift measure or two or more drift measures. In various examples, a drift measure obtained in the block 802 may be a position value, a velocity value, or an acceleration value. In some examples, a drift measure is obtained by processing one or more image frames, e.g., as described above in reference to Eqs. (1)-(5).

In at least some examples, different instances of the block 802 are performed in different occurrences of a processing loop including blocks 802-808. In some examples, an instance of the block 802 includes obtaining a drift measure corresponding to a first portion of the sample S. In some other examples, an instance of the block 802 includes obtaining a drift measure corresponding to a second portion of the sample S. The electron-beam illumination spots $214_1$ and $214_2$ illustrated in FIG. 5 provide nonlimiting examples of such first and second portions, respectively.

The method 800 also includes computing a drift estimate (in the block 804). In various examples, the drift estimate is computed in the block 804 based the set(s) of drift measures obtained in one or more preceding instances of the block 802. For at least some instances of the processing loop 802-808, operations of the block 804 include computing the drift estimate based at least in part on one or more drift measures obtained from a set of image frames acquired from the above-mentioned first portion of the sample. For at least some instances of the processing loop 802-808, operations of the block 804 include computing the drift estimate based at least in part on one or more drift measures obtained from a set of image frames acquired from the above-mentioned second portion of the sample. For at least some instances of the processing loop 802-808, operations of the block 804 include computing the drift estimate based on (i) one or more drift measures obtained from a set of image frames acquired from the above-mentioned first portion of the sample and (ii) one or more drift measures obtained from a set of image frames acquired from the above-mentioned second portion of the sample.

In some examples, operations of the block 804 include updating the previously computed drift estimate, e.g., using a recursive update algorithm. The algorithm 300 is a nonlimiting example of such recursive update algorithm. In some examples, the previously computed drift estimate is obtained using the following operations: (i) computing a first sequence of drift measures using different subsets of a set of image frames acquired from the above-mentioned first portion of the sample; and (ii) applying the first sequence to a first smoothing filter. Then, the previously computed drift estimate is updated using the following operations: (i) computing a second sequence of drift measures using different subsets of a set of image frames acquired from the above-mentioned second portion of the sample; and (ii) applying the second sequence to a different second smoothing filter. In some examples, the second smoothing filter is the same as the first smoothing filter, and the second sequence is applied thereto after the first sequence, e.g., as described above in reference to the Kalman filter 302.

The method 800 also includes performing drift compensation (in the block 806). In some examples, operations of the block 806 include generating one or more control signals based at least in part on the drift estimate computed in the block 804 and applying such control signals to one or both of the electron beam column 102 and the stage 110. In some examples, operations of the block 806 include controlling actuation of a stage with which the sample is coupled. In some examples, operations of the block 806 include controlling a charged particle optical element of the charged particle beam column to apply beam correction corresponding to the drift estimate.

As already indicated above, different instances of the block 806 are performed in different occurrences of the processing loop 802-808. In some examples, an instance of the block 806 includes performing the drift compensation when the charged particle beam is illuminating the above-mentioned first portion of the sample. In some examples, an instance of the block 806 includes performing the drift compensation when the charged particle beam is illuminating the above-mentioned second portion of the sample.

Operations of the decision block 808 control the exit from the processing loop 802-808 and include determining whether the image acquisition is finished. In some examples, this determination of the decision block 808 includes comparing the cumulative radiation dose to which the second portion of the sample has been subjected with a fixed (e.g., preselected) threshold value. In some other examples, this determination of the decision block 808 includes running a timer to count the cumulative irradiation time for the second portion of the sample and comparing the cumulative irradiation time with a fixed (e.g., preselected) duration. In yet other examples, other suitable (e.g., sample-specific) exit criteria can similarly be used in the decision block 808.

When it is determined that the image acquisition is not finished ("No" at the decision block 808), the method 800 is looped back to the block 802. When it is determined that the image acquisition is finished ("Yes" at the decision block 808), the method 800 is terminated.

FIG. 9 is a block diagram illustrating a computing device 900 according to some examples. In various examples, the electronic controller 150 may be implemented by a single computing device 900 or by multiple computing devices 900. In some examples, an instance of the computing device 900 can be used to implement the algorithm 300 and/or the method 600.

The computing device 900 of FIG. 9 is illustrated as having a number of components, but any one or more of these components may be omitted or duplicated, as suitable for the application and setting. In some embodiments, some or all of the components included in the computing device 900 may be attached to one or more motherboards and enclosed in a housing. In some embodiments, some of those components may be fabricated onto a single system-on-a-chip (SoC) (e.g., the SoC may include one or more electronic processing devices 902 and one or more storage devices 904). Additionally, in various embodiments, the computing device 900 may not include one or more of the components illustrated in FIG. 9, but may include interface circuitry for coupling to the one or more components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface). For example, the computing device 900 may not include a display device 910, but may include display device interface circuitry (e.g., a connector and driver circuitry) to which an external display device 910 may be coupled.

The computing device 900 includes a processing device 902 (e.g., one or more processing devices). As used herein, the terms "electronic processor device" and "processing device" interchangeably refer to any device or portion of a device that processes electronic data from registers and/or memory to transform that electronic data into other electronic data that may be stored in registers and/or memory. In various embodiments, the processing device 902 may include one or more digital signal processors (DSPs), application-specific integrated circuits (ASICs), central processing units (CPUs), graphics processing units (GPUs), server processors, field programmable gate arrays (FPGA), or any other suitable processing devices.

The computing device 900 also includes a storage device 904 (e.g., one or more storage devices). In various embodiments, the storage device 904 may include one or more memory devices, such as random-access memory (RAM) devices (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some embodiments, the storage device 904 may include memory that shares a die with the processing device 902. In such an embodiment, the memory may be used as cache memory and include embedded dynamic random-access memory (eDRAM) or spin transfer torque magnetic random-access memory (STT-MRAM), for example. In some embodiments, the storage device 904 may include non-transitory computer readable media having instructions thereon that, when executed by one or more processing devices (e.g., the processing device 902), cause the computing device 900 to perform any appropriate ones of the methods disclosed herein below or portions of such methods.

The computing device 900 further includes an interface device 906 (e.g., one or more interface devices 906). In various embodiments, the interface device 906 may include one or more communication chips, connectors, and/or other hardware and software to govern communications between the computing device 900 and other computing devices. For example, the interface device 906 may include circuitry for managing wireless communications for the transfer of data to and from the computing device 900. The term "wireless" and its derivatives may be used to describe circuits, devices, systems, methods, techniques, communications channels, etc., that may communicate data via modulated electromagnetic radiation through a nonsolid medium. The term does not imply that the associated devices do not contain any wires, although in some embodiments they might not. Circuitry included in the interface device 906 for managing wireless communications may implement any of a number of wireless standards or protocols, including but not limited to Institute for Electrical and Electronic Engineers (IEEE) standards including Wi-Fi (IEEE 802.11 family), IEEE 802.16 standards, Long-Term Evolution (LTE) project along with any amendments, updates, and/or revisions (e.g., advanced LTE project, ultramobile broadband (UMB) project (also referred to as "3GPP2"), etc.). In some embodiments, circuitry included in the interface device 906 for managing wireless communications may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some embodiments, circuitry included in the interface device 906 for managing wireless communications may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some embodiments, circuitry included in the interface device 906 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some embodiments, the interface device 906 may include one or more antennas (e.g., one or more antenna arrays) configured to receive and/or transmit wireless signals.

In some embodiments, the interface device 906 may include circuitry for managing wired communications, such as electrical, optical, or any other suitable communication protocols. For example, the interface device 906 may include circuitry to support communications in accordance with Ethernet technologies. In some embodiments, the interface device 906 may support both wireless and wired communication, and/or may support multiple wired communication protocols and/or multiple wireless communication protocols. For example, a first set of circuitry of the interface device 906 may be dedicated to shorter-range wireless communications such as Wi-Fi or Bluetooth, and a second set of circuitry of the interface device 906 may be dedicated to longer-range wireless communications such as global positioning system (GPS), EDGE, GPRS, CDMA, WiMAX, LTE, EV-DO, or others. In some other embodiments, a first set of circuitry of the interface device 906 may be dedicated to wireless communications, and a second set of circuitry of the interface device 906 may be dedicated to wired communications.

The computing device 900 also includes battery/power circuitry 908. In various embodiments, the battery/power circuitry 908 may include one or more energy storage devices (e.g., batteries or capacitors) and/or circuitry for coupling components of the computing device 900 to an energy source separate from the computing device 900 (e.g., to AC line power).

The computing device 900 also includes a display device 910 (e.g., one or multiple individual display devices). In various embodiments, the display device 910 may include any visual indicators, such as a heads-up display, a computer monitor, a projector, a touchscreen display, a liquid crystal display (LCD), a light-emitting diode display, or a flat panel display.

The computing device 900 also includes additional input/output (I/O) devices 912. In various embodiments, the I/O devices 912 may include one or more data/signal transfer interfaces, audio I/O devices (e.g., microphones or microphone arrays, speakers, headsets, earbuds, alarms, etc.), audio codecs, video codecs, printers, sensors (e.g., thermocouples or other temperature sensors, humidity sensors, pressure sensors, vibration sensors, etc.), image capture devices (e.g., one or more cameras), human interface devices (e.g., keyboards, cursor control devices, such as a mouse, a stylus, a trackball, or a touchpad), etc.

Depending on the specific embodiment of the system 100, various components of the interface devices 906 and/or I/O devices 912 can be configured to send and receive suitable control messages, suitable control/telemetry signals, and streams of data. In some examples, the interface devices 906 and/or I/O devices 912 include one or more analog-to-digital converters (ADCs) for transforming received analog signals into a digital form suitable for operations performed by the processing device 902 and/or the storage device 904. In some additional examples, the interface devices 906 and/or I/O devices 912 include one or more digital-to-analog converters (DACs) for transforming digital signals provided by the processing device 902 and/or the storage device 904 into an analog form suitable for being communicated to the corresponding components of the system 100.

According to one example disclosed above, e.g., in the summary section and/or in reference to any one or any combination of some or all of FIGS. 1-9, provided is a method performed via a computing device for providing support to a charged particle beam system, the method comprising: computing a drift estimate based at least in part on a first set of image frames acquired with a charged particle beam column and a detector from a first portion of a sample; configuring the charged particle beam column and the detector to acquire a second set of image frames from a second portion of the sample; and performing drift compensation during acquisition of the second set of image frames based at least in part on the drift estimate.

In some examples of the above method, performing the drift compensation includes controlling actuation of a stage with which the sample is coupled.

In some examples of any of the above methods, performing the drift compensation includes controlling a charged particle optical element of the charged particle beam column to correct for the drift estimate.

In some examples of any of the above methods, the method further comprises modulating a beam of charged particles directed to the sample via the charged particle beam column in accordance with a pulsed gating signal.

In some examples of any of the above methods, the pulsed gating signal is configured to have a first duty cycle value when the beam is directed to the first portion of the sample and a different second duty cycle value when the beam is directed to the second portion of the sample.

In some examples of any of the above methods, the first set of image frames includes a first subset and a second subset, the second subset being acquired later than the first subset; and wherein performing the drift compensation includes performing the drift compensation during acquisition of the second subset based at least in part on a preliminary value of the drift estimate computed based at least in part on the first subset.

In some examples of any of the above methods, the second set of image frames includes a first subset and a second subset, the second subset being acquired later than the first subset; and wherein the method further comprises updating the drift estimate based at least in part on the first subset; and wherein the performing the drift compensation includes performing the drift compensation during acquisition of the second subset based at least in part on the updated drift estimate.

In some examples of any of the above methods, computing the drift estimate includes determining one or more displacement vectors based at least in part on the first set of image frames.

In some examples of any of the above methods, computing the drift estimate includes: computing a sequence of drift measures using different subsets of the first set of image frames; and determining the drift estimate based at least in part on the sequence.

In some examples of any of the above methods, the method further comprises updating the drift estimate using one or more image frames of the second set of image frames.

In some examples of any of the above methods, computing the drift estimate includes: computing a first sequence of drift measures using different subsets of the first set of image frames; and applying the first sequence to a smoothing filter; and wherein updating the drift estimate includes: computing a second sequence of drift measures using different subsets of the second set of image frames; and applying the second sequence to the smoothing filter after the first sequence.

In some examples of any of the above methods, a drift measure in the first and second sequences is selected from a group consisting of a position value, a velocity value, and an acceleration value.

In some examples of any of the above methods, the smoothing filter is configured to perform multiple predictions at a juncture between the first and second sequences.

A non-transitory computer-readable medium storing instructions that, when executed by the computing device, cause the computing device to perform operations comprising any one of the above methods.

According to another example disclosed above, e.g., in the summary section and/or in reference to any one or any combination of some or all of FIGS. 1-9, provided is a charged particle beam system, comprising: a charged particle beam column configured to direct a beam of charged particles to a sample; a detector configured to detect a response of the sample to the beam of charged particles; and an electronic controller configured to: compute a drift estimate based at least in part on a first set of image frames acquired with the charged particle beam column and the detector from a first portion of the sample; configure the charged particle beam column and the detector to acquire a second set of image frames from a second portion of the sample; and perform drift compensation during acquisition of the second set of image frames based at least in part on the drift estimate.

In some examples of the above system, the system further comprises a stage with which the sample is coupled, wherein the electronic controller is configured to perform the drift compensation by controlling actuation of the stage based at least in part on the drift estimate.

In some examples of any of the above systems, the electronic controller is configured to perform the drift compensation by controlling the charged particle beam column to perform beam deflection based at least in part on the drift estimate.

In some examples of any of the above systems, the first set of image frames and the second set of image frames represent transmission electron microscope (TEM) images.

In some examples of any of the above systems, the first set of image frames and the second set of image frames represent scanning transmission electron microscope (STEM) images.

In some examples of any of the above systems, the first portion and the second portion are non-overlapping portions of the sample.

According to yet another example disclosed above, e.g., in the summary section and/or in reference to any one or any combination of some or all of FIGS. 1-9, provided is a method performed via a computing device for providing support to a charged particle beam system, the method comprising: computing a drift estimate based at least in part on a first set of image frames acquired with a charged particle beam column and a detector from a first portion of a sample; configuring a stage with which the sample is coupled to move the sample relative to the detector to cause the charged particle beam column and the detector to acquire a second set of image frames from a second portion of the sample; and performing drift compensation during acquisition of the second set of image frames based at least in part on the drift estimate.

It is to be understood that the above description is intended to be illustrative and not restrictive. Many implementations and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future examples. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary is made herein. In particular, use of the singular articles such as "a," "the," "said," etc. should be read to recite one or more of the indicated elements unless a claim recites an explicit limitation to the contrary.

The Abstract is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various examples for the purpose of streamlining the disclosure. This method of disclosure is not to be interpreted as reflecting an intention that the claimed subject matter incorporate more features than are expressly recited in each claim. Rather, as the following claims reflect, inventive subject matter lies in fewer than all features of a single disclosed example. Thus, the following claims are hereby incorporated into the Detailed Description, with each claim standing on its own as a separately claimed subject matter.

Unless explicitly stated otherwise, each numerical value and range should be interpreted as being approximate as if the word "about" or "approximately" preceded the value or range.

Although the elements in the following method claims, if any, are recited in a particular sequence with corresponding labeling, unless the claim recitations otherwise imply a particular sequence for implementing some or all of those elements, those elements are not necessarily intended to be limited to being implemented in that particular sequence.

Unless otherwise specified herein, the use of the ordinal adjectives "first," "second," "third," etc., to refer to an object of a plurality of like objects merely indicates that different instances of such like objects are being referred to, and is not intended to imply that the like objects so referred-to have to be in a corresponding order or sequence, either temporally, spatially, in ranking, or in any other manner.

Unless otherwise specified herein, in addition to its plain meaning, the conjunction "if" may also or alternatively be construed to mean "when" or "upon" or "in response to determining" or "in response to detecting," which construal may depend on the corresponding specific context. For example, the phrase "if it is determined" or "if [a stated condition] is detected" may be construed to mean "upon determining" or "in response to determining" or "upon detecting [the stated condition or event]" or "in response to detecting [the stated condition or event]."

Also for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

The functions of the various elements shown in the figures, including any functional blocks labeled as "processors" and/or "controllers," may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

As used in this application, the terms "circuit," "circuitry" may refer to one or more or all of the following: (a) hardware-only circuit implementations (such as implementations in only analog and/or digital circuitry); (b) combinations of hardware circuits and software, such as (as applicable): (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions); and (c) hardware circuit(s) and or processor(s), such as a microprocessor(s) or a portion of a microprocessor(s), that requires software (e.g., firmware) for operation, but the software may not be present when it is not needed for operation." This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

It should be appreciated by those of ordinary skill in the art that any block diagrams herein represent conceptual views of illustrative circuitry embodying the principles of the disclosure. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

**Claims**

1. A method performed via a computing device for providing support to a charged particle beam system, the method comprising:

   computing a drift estimate based at least in part on a first set of image frames acquired with a charged particle beam column and a detector from a first portion of a sample;
   configuring the charged particle beam column and the detector to acquire a second set of image frames from a second portion of the sample; and
   performing drift compensation during acquisition of the second set of image frames based at least in part on the drift estimate.

2. The method of claim 1, wherein performing the drift compensation includes controlling actuation of a stage with which the sample is coupled.

3. The method of claim 1 , wherein performing the drift compensation includes controlling a charged particle optical element of the charged particle beam column to correct for the drift estimate.

4. The method of claim 1, claim 2 or claim 3, further comprising modulating a beam of charged particles directed to the sample via the charged particle beam column in accordance with a pulsed gating signal.

5. The method of claim 4, wherein the pulsed gating signal is configured to have a first duty cycle value when the beam is directed to the first portion of the sample and a different second duty cycle value when the beam is directed to the second portion of the sample.

6. The method of any one of the preceding claims,

   wherein the first set of image frames includes a first subset and a second subset, the second subset being acquired later than the first subset; and
   wherein performing the drift compensation includes performing the drift compensation during acquisition of the second subset based at least in part on a preliminary value of the drift estimate computed based at least in part on the first subset.

7. The method of any one of the preceding claims,

   wherein the second set of image frames includes a first subset and a second subset, the second subset being acquired later than the first subset; and
   wherein the method further comprises updating the drift estimate based at least in part on the first subset; and
   wherein the performing the drift compensation includes performing the drift compensation during acquisition of the second subset based at least in part on the updated drift estimate.

8. The method of any one of the preceding claims, wherein computing the drift estimate includes determining one or more displacement vectors based at least in part on the first set of image frames.

9. The method of any one of the preceding claims, wherein computing the drift estimate includes:

   computing a sequence of drift measures using different subsets of the first set of image frames; and
   determining the drift estimate based at least in part on the sequence.

10. The method of any one of the preceding claims, further comprising updating the drift estimate using one or more image frames of the second set of image frames.

11. The method of claim 10,

wherein computing the drift estimate includes:

computing a first sequence of drift measures using different subsets of the first set of image frames; and
applying the first sequence to a smoothing filter; and

wherein updating the drift estimate includes:

computing a second sequence of drift measures using different subsets of the second set of image frames; and
applying the second sequence to the smoothing filter after the first sequence.

12. The method of any preceding claim, wherein the first set of image frames and the second set of image frames represent transmission electron microscope (TEM) or scanning transmission electron microscope (STEM) images.

13. The method of claim 11, wherein the smoothing filter is configured to perform multiple predictions at a juncture between the first and second sequences.

14. A non-transitory computer-readable medium storing instructions that, when executed by the computing device, cause the computing device to perform operations comprising the method of any one of the preceding claims.

15. A charged particle beam system, comprising:

a charged particle beam column configured to direct a beam of charged particles to a sample;
a detector configured to detect a response of the sample to the beam of charged particles; and
an electronic controller comprising a computing device upon which is stored computer program code, the computer program code when executed being configured to carry out the method steps of any one of claims 1-13.

FIG. 1

FIG. 2

FIG. 3

EP 4 657 489 A2

FIG. 4

FIG. 5

EP 4 657 489 A2

FIG. 6

EP 4 657 489 A2

Position

$214_2$

$214_1$

$502$

$t_2$

time

FIG. 7A

Gating

ON

OFF

$t_2$

time

160

702

704

FIG. 7B

EP 4 657 489 A2

FIG. 8

FIG. 9

## REFERENCES CITED IN THE DESCRIPTION

**Patent documents cited in the description**

- US 65753424

- US 20190228949

**Non-patent literature cited in the description**

- **E.P. VAN HORSSEN ; B.J. JANSSEN ; A. KUMAR et al.** Image-based feedback control for drift compensation in an electron microscope. *IFAC Journal of Systems and Control*, 2020, vol. 11, 100074-100088